# EUROPÄISCHE PATENTANMELDUNG

(11) **EP 1 320 289 A1**
(43) Veröffentlichungstag der Anmeldung: **18.06.2003**
(21) Anmeldenummer: 02027516.0
(22) Anmeldetag: 06.12.2002
(51) Int. Cl.: H05K 5/06, H05K 5/00, H05K 7/20

(54) **Hermetisch dichtes Gehäuse**

(30) Priorität: 17.12.2001 DE 20120373 U
(71) Anmelder: Harting Automotive GmbH & Co. KG, 32339 Espelkamp (DE)
(72) Erfinder: Krause, Jens, Dr., 32369 Rahden (DE); Heimann, Thomas, 32339 Espelkamp (DE)
(74) Vertreter: Sties, Jochen, Dipl.-Ing.

(57) **Zusammenfassung**

Hermetisch dichtes Gehäuse für eine Leistungselektronik, mit einer Wanne (10), die aus Metall besteht und mindestens eine Seitenwand (19) aufweist, in der mindestens eine Aussparung (26) vorgesehen ist, einem Deckel (12), der hermetisch dicht an der Wanne (10) angebracht werden kann, und einer Isolierplatte (32), die aus Kunststoff besteht und an der mindestens eine Stromdurchführung (36) vorgesehen ist, wobei die Isolierplatte (32) so an der Seitenwand (19) befestigt ist, dass die Stromdurchführung (36) durch die Aussparung (26) hindurchragt, dadurch gekennzeichnet, dass zwischen der Isolierplatte (32) und der Seitenwand (19) des Gehäuses flächig ein dauerelastischer Dicht- und Klebstoff (42) angeordnet ist.

## Beschreibung

Die Erfindung betrifft ein hermetisch dichtes Gehäuse für die Siedebadkühlung einer Leistungselektronik, mit einer Wanne, die aus Metall besteht und mindestens eine Seitenwand aufweist, in der mindestens eine Aussparung vorgesehen ist, einem Deckel, der hermetisch dicht an der Wanne angebracht werden kann, und einer Isolierplatte, die aus Kunststoff besteht und an der mindestens eine Stromdurchführung vorgesehen ist, wobei die Isolierplatte so an der Seitenwand befestigt ist, daß die Stromdurchführung durch die Aussparung hindurchragt.

Ein solches Gehäuse ist aus dem Deutschen Gebrauchsmuster 200 20 270 bekannt. Es dient dazu, die Verlustwärme der Leistungselektronik zuverlässig abzuführen, damit es nicht zu einer Überhitzung der Leistungselektronik kommt. Unter dem Begriff "Leistungselektronik" wird dabei eine Baugruppe aus mindestens einem elektronischen Bauteil verstanden, in welchem hohe elektrische Leistungen umgesetzt werden, so daß eine große Menge an Verlustwärme anfällt. Gemäß einer bevorzugten Anwendung des erfindungsgemäßen Gehäuses handelt es sich bei der Leistungselektronik um den Wechselrichter eines sogenannten Starter-Generators, der die bisher getrennt ausgeführten Bauteile Anlasser und Lichtmaschine eines Kraftfahrzeugs vereinigt.

Bei der Siedebadkühlung sind die Bauteile der Leistungselektronik unmittelbar von einer Kühlflüssigkeit umgeben, die von dem Gehäuse aufgenommen ist, in welchem auch die Leistungselektronik angeordnet ist. Vorzugsweise sind die zu kühlenden Bauteile ohne ein Gehäuse ausgeführt, so daß die Kühlflüssigkeit unmittelbar mit den Bereichen des Bauteils in Berührung steht, an denen die Verlustwärme anfällt. Im Falle von Halbleiterchips steht also direkt die Oberfläche des Siliziumchips mit der Kühlflüssigkeit in Verbindung.

Die Kühlflüssigkeit ist so gewählt, daß sie im Betrieb der Leistungselektronik an den Bereichen der Bauteile, in denen die Verlustwärme anfällt, siedet. Die entstehenden Dampfblasen steigen auf und werden an kühleren Abschnitten des Gehäuses, insbesondere am Deckel, kondensiert, so daß sie wieder als Kühlflüssigkeit für einen neuen Verdampfungsprozeß zur Verfügung stehen. Dieses Kühlungsverfahren ist besonders effektiv, da beim Phasenübergang der Kühlflüssigkeit von flüssig zu dampfförmig eine sehr viel größere Energiemenge aufgenommen wird, als dies bei einer reinen Flüssigkeitskühlung der Fall wäre.

Das Problem bei der Siedebadkühlung besteht darin, daß bei jeder Inbetriebnahme der Leistungselektronik die Temperatur der Kühlflüssigkeit und damit einhergehend der Innendruck im Gehäuse ansteigt. Diese zyklische Druckbeanspruchung stellt eine erhebliche mechanische Belastung für die Stromdurchführung durch die Wandung des Gehäuses dar. Wenn ein solches Gehäuse für den Einsatz in Kraftfahrzeugen vorgesehen ist, muß gewährleistet sein, daß das Gehäuse auch nach einer Betriebsdauer von 15 Jahren noch dicht ist, da ansonsten eine Kühlung der Leistungselektronik nicht gewährleistet ist.

Bei dem bekannten Gehäuse ist am Rand der Isolierplatte als Dichtung ein O-Ring vorgesehen, der in einer Nut in der Isolierplatte angeordnet ist und an der Seitenwand der Wanne anliegt. Die Nut in der Isolierplatte muß jedoch mit sehr großer Genauigkeit und mit hoher Oberflächenqualität gefertigt werden, wenn die erforderliche zuverlässige Abdichtung über eine lange Betriebsdauer aufrechterhalten werden soll.

Die Aufgabe der Erfindung besteht darin, ein Gehäuse für eine Siedebadkühlung einer Leistungselektronik zu schaffen, bei dem die Stromdurchführung durch die Seitenwand der Wanne mit geringerem Aufwand abgedichtet werden kann.

Zur Lösung dieser Aufgabe ist erfindungsgemäß bei einem Gehäuse der eingangs genannten Art vorgesehen, daß zwischen der Isolierplatte und der Seitenwand des Gehäuses flächig ein dauerelastischer Dicht- und Klebstoff angeordnet ist. Die Erfindung beruht auf der Erkenntnis, daß es trotz der Unterschiede bei der Wärmeausdehnung der Seitenwand des Gehäuses einerseits und der Isolierplatte andererseits möglich ist, eine vollflächige Verklebung zwischen der Isolierplatte und der Seitenwand des Gehäuses zu verwenden. Aufgrund der zur Verfügung stehenden großen Klebefläche hat die Klebung eine solche Festigkeit, daß die Dichtigkeit zwischen der Isolierplatte und der Seitenwand des Gehäuses auch nach einer sehr hohen Anzahl von Betriebszyklen nicht beeinträchtigt ist. Bisher wurde dagegen davon ausgegangen, daß es aufgrund des unterschiedlichen Wärmeausdehnungsverhaltens erforderlich ist, zur Abdichtung einen O-Ring zu verwenden, der einen größeren Spielraum für eine Relativbewegung zwischen den beiden Teilen bietet. Wenn aber die erfindungsgemäß vorgesehene, flächige Verklebung verwendet wird, müssen keine so hohen Anforderungen hinsichtlich der Oberflächenqualität der Isolierplatte mehr eingehalten werden, so daß die Herstellungskosten sinken.

Vorzugsweise besteht die Wanne aus Stahl, Aluminium oder einer Aluminiumlegierung, und als dauerelastischer Dicht- und Klebstoff wird ein solcher verwendet, wie er aus dem Flugzeugbau zum Verkleben von zwei Aluminiumlegierungen bekannt ist. Es wurde nun herausgefunden, daß ein solcher Dicht- und Klebstoff auch dann geeignet ist, wenn unterschiedliche Materialien verklebt werden sollen, nämlich eine Kunststoffplatte mit einer Metallplatte. Die dauerelastische Dicht- und Klebstoffschicht ist temperaturbeständig bis 160°C bei einem Innenüberdruck von bis zu 3 bar. Dabei ist sie beständig gegen das vorzugsweise als Kühlflüssigkeit verwendete FKW. Ein solcher geeigneter Dichtund Klebstoff enthält vorzugsweise Polysulfid.

Gemäß der bevorzugten Ausführungsform der Erfindung ist auf der der Seitenwand des Gehäuses zugewandten Seite der Isolierplatte eine Depotnut vorgesehen, die sich entlang dem Außenrand der Isolierplatte erstreckt. Die Tiefe der Depotnut kann zwischen 0,5 und 1,5 mm betragen. Der in der Depotnut vorhandene Dicht- und Klebstoff wirkt aufgrund seines sehr großen Querschnitts wie ein Dichtungsstreifen mit rechteckigem Querschnitt, der vergleichsweise flexibel ist.

Gemäß der bevorzugten Ausführungsform sind auf der der Seitenwand des Gehäuses zugewandten Seite der Isolierplatte mehrere Abstandshalter vorgesehen, die sich an der Seitenwand abstützen. Die Abstandshalter, die als pyramidenförmige Vorsprünge mit einer Höhe zwischen 0,1 und 0,5 mm ausgeführt sein können, gewährleisten eine konstante Dicke der dauerelastischen Dicht- und Klebstoffschicht. Die Vorsprünge sind an der Isolierplatte so verteilt, daß die Anpreßkraft, die später beim Verkleben der Isolierplatte mit der Seitenwand aufgebracht wird, nicht zu einer Durchbiegung der Isolierplatte führt. Die Abstandshalter müssen daher nicht gleichmäßig über die gesamte Fläche der Isolierplatte verteilt sein, sondern können auf die Bereiche begrenzt sein, in denen später die Anpreßkraft aufgebracht wird. Die Verwendung von pyramidenförmigen Abstandshaltern hat den Vorteil, daß die Spitze der Pyramide die aufgebrachte Klebstoffschicht zuverlässig durchdringt und, aufgrund der sich ergebenden hohen Flächenpressung, mechanisch in die Seitenwand eingreift, so daß die Isolierplatte nicht auf der Klebstoffschicht schwimmt und es zu einer fehlerhaften Ausrichtung kommen kann.

Es können mehrere Niete vorgesehen sein, mittels denen die Isolierplatte an der Seitenwand befestigt ist. Die Niete sind jedoch nicht erforderlich, um die Isolierplatte während des Betriebs des Gehäuses mechanisch an der Seitenwand zu halten; aufgrund des beim Betrieb auftretenden Überdrucks im Inneren des Gehäuses wird die Isolierplatte automatisch gegen die Seitenwand gedrückt. Die Niete haben lediglich die Funktion, die Anpreßkraft zwischen der Isolierplatte und der Seitenwand des Gehäuses aufzubringen, nachdem das Gehäuse mit der Isolierplatte aus dem Preßwerkzeug entnommen wurde, welches anfangs die Anpreßkraft aufbringt. Würden keine Niete verwendet, müßte das Gehäuse so lange in dem Preßwerkzeug verbleiben, bis der Dicht- und Klebstoff ausgehärtet hat.

Die Isolierplatte besteht vorzugsweise aus einem teilkristallinen und kapillardichten Kunststoff, insbesondere PPS, der zusätzlich faserverstärkt sein kann. Auf diese Weise ergibt sich die notwendige Festigkeit und Diffusionsdichte.

Vorteilhafte Ausgestaltungen der Erfindung ergeben sich aus den Unteransprüchen.

Die Erfindung wird nachfolgend anhand einer bevorzugten Ausführungsform beschrieben, die in den beigefügten Zeichnungen dargestellt ist. In diesen zeigen:
- Figur 1 in einer perspektivischen Ansicht ein erfindungsgemäßes Gehäuse;
- Figur 2 in einer perspektivischen Ansicht eine Wanne für das Gehäuse von Figur 1;
- Figur 3 eine Seitenansicht des Gehäuses von Figur 2;
- Figur 4 in vergrößertem Maßstab den Ausschnitt IV von Figur 3;
- Figur 5 eine weitere Seitenansicht des Gehäuses von Figur 2;
- Figur 6 in einer perspektivischen Ansicht die mit der Isolierplatte versehene Seitenwand des Gehäuses von innen;
- Figur 7 einen Schnitt entlang der Ebene VII-VII von Figur 6; und
- Figur 8 in vergrößertem Maßstab den Ausschnitt VIII von Figur 7.

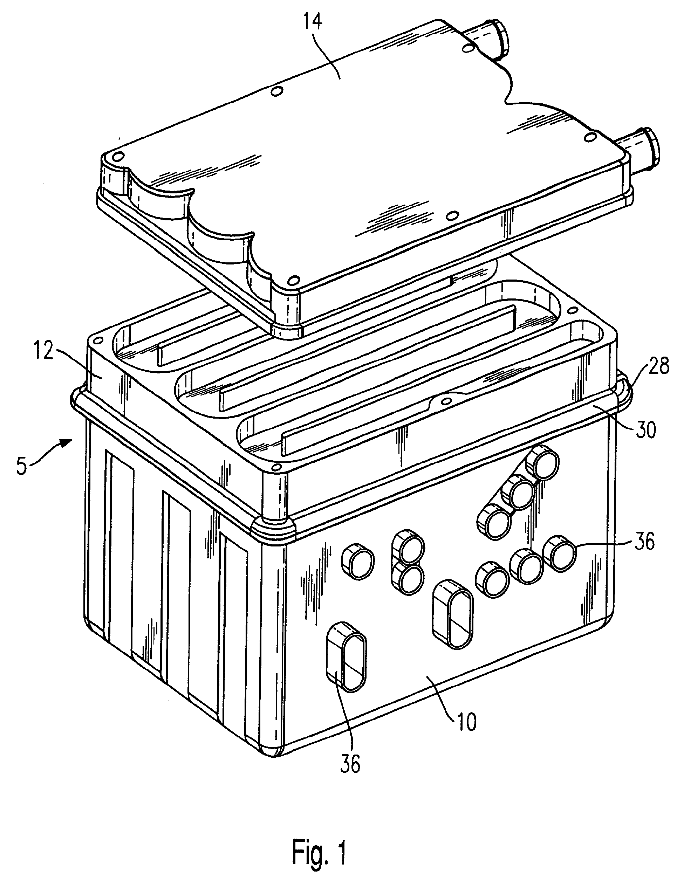

In Figur 1 ist ein Gehäuse 5 gezeigt, das eine Wanne 10, einen Deckel 12 sowie eine auf den Deckel aufgesetzte Abdeckung 14 aufweist.

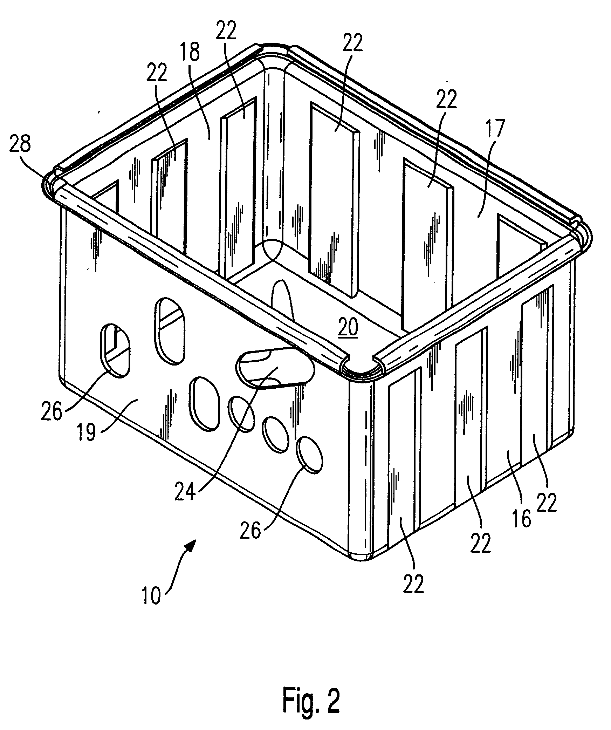

Die Wanne 10 (siehe auch die Figuren 2 bis 5) ist ein tiefgezogenes Stahlblechteil mit einer Wandstärke von etwa 2,5 mm und hat einen rechteckigen Querschnitt mit vier Seitenwänden 16, 17, 18, 19 und einem Boden 20. Alternativ könnte auch eine Wanne verwendet werden, deren Wände und Boden aus einer Aluminiumlegierung bestehen und zusammengeschweißt sind. Die Seitenwände 16, 17, 18 sind mit jeweils drei Sicken 22 versehen, die sich ausgehend vom Boden 20 nach oben erstrecken. Der Boden 20 ist mit einer Kreuzsicke 24 versehen. Die ebene Seitenwand 19, die mit keiner Sicke versehen ist, weist mehrere Aussparungen 26 auf, deren Funktion später erläutert wird.

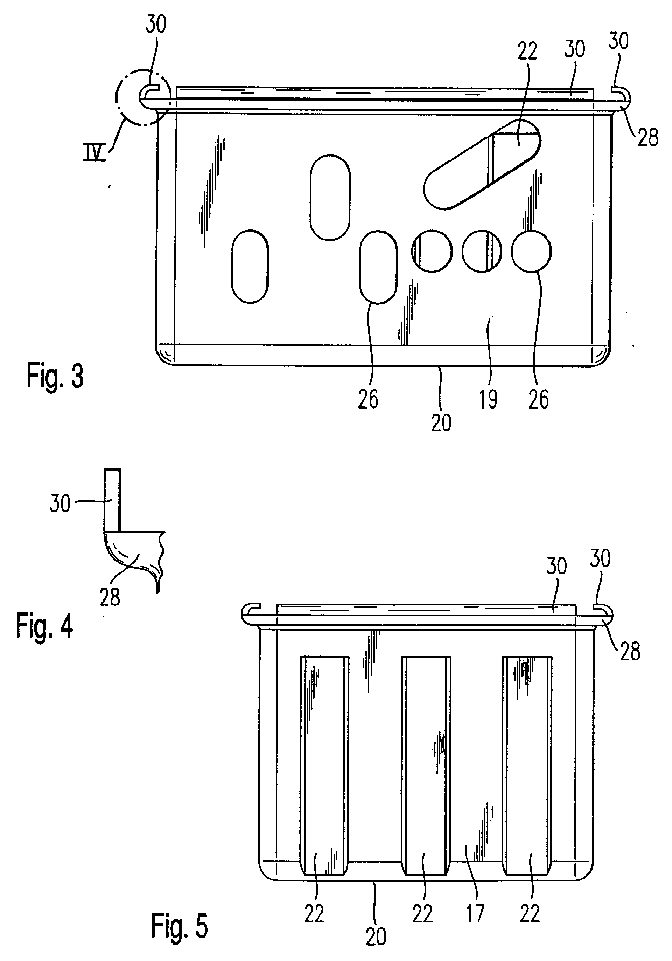

Die Wanne 10 ist auf ihrer vom Boden 20 abgewandten Seite mit einem umlaufenden Rand 28 versehen, der als über die Seitenwände nach außen hervorstehender Kragen ausgebildet ist. Der Rand 28 ist im Bereich jeder Seitenfläche mit einer Biegelasche 30 versehen, die in Figur 4 in ihrem Ausgangszustand und in den Figuren 2, 3 und 5 in ihrer umgebogenen Form gezeigt sind, in die sie zum Befestigen des Deckels an der Wanne gebracht werden.

Der Deckel 12, der dafür vorgesehen ist, auf die Wanne 10 aufgesetzt zu werden, ist ein Gußteil aus einer Aluminium-Legierung. Es ist grundsätzlich auch möglich, einen geeignet gegossenen Rohling durch Fließpressen oder ein ähnliches Bearbeitungsverfahren in seine endgültige Form zu bringen.

Auf den Deckel 12 wird eine Abdeckung 14 (siehe Figur 1) aufgesetzt, die aus Kunststoff besteht. Die Abdeckung 14 ist mit zwei Anschlußstutzen versehen, an die Kühlleitungen angeschlossen werden können, um ein geeignetes Kühlmedium durch einen Kühlkanal im Deckel 12 zu leiten.

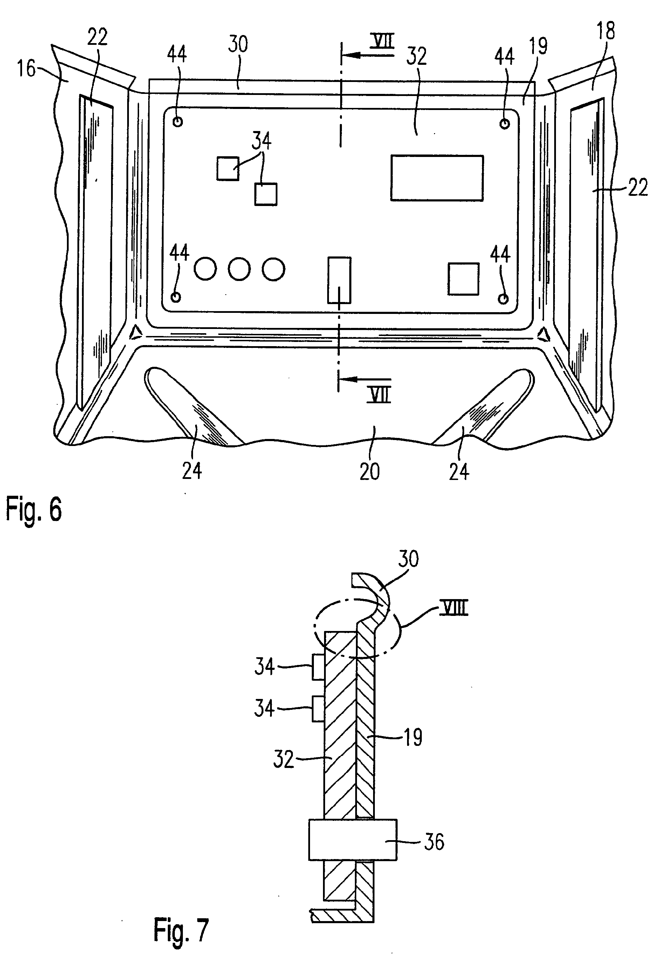

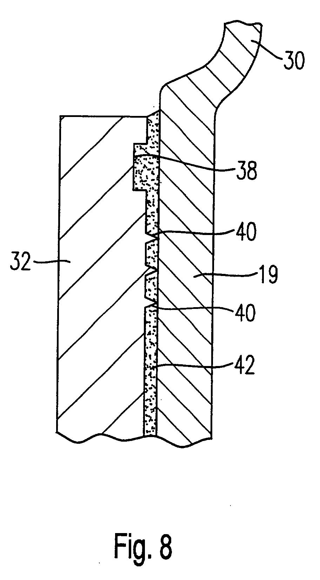

In Figur 6 ist eine Isolierplatte 32 gezeigt, die rechteckig ist und deren Abmessungen etwa denjenigen der Seitenwand 19 entsprechen. Die Isolierplatte 32 besteht aus einem isolierenden Kunststoffinaterial, beispielsweise einem teilkristallinen und diffusionsdichten Kunststoff wie PPS, und trägt eine Leistungselektronik, die hier nur schematisch durch einige Bauteile 34 gezeigt ist. Die Isolierplatte 32 ist mit mehreren Stromdurchführungen 36 versehen, deren Anordnung auf der Isolierplatte 32 und deren Abmessungen mit der Anordnung und den Abmessungen der Aussparungen 26 in der Seitenwand 19 der Wanne übereinstimmt. Die Stromdurchführungen 36 ermöglichen es, die Leistungselektronik 34 im Fahrzeug anzuschließen. Die Isolierplatte 32 ist auf ihrer der Seitenwand 19 der Wanne zugewandten Seite mit einer Depotnut 38 (siehe Figur 8) versehen, die eine Tiefe von etwa 1 mm sowie einen rechteckigen Querschnitt hat. Die Depotnut 38 verläuft entlang dem gesamten Rand der Isolierplatte 32, so daß sie geschlossen ist. Innerhalb des von der Depotnut 38 umschlossenen Bereichs sind auf der der Seitenwand 19 des Gehäuses zugewandten Seite der Isolierplatte 32 mehrere Abstandshalter 40 ausgebildet, die hier die Form von spitzen Pyramiden haben. Jeder Abstandshalter hat eine Höhe von etwa 0,3 mm. Die mit der Depotnut 38 und den Abstandshaltern 40 versehene Isolierplatte 32 kann mit geringem Aufwand von einer geeigneten Gußform abgeformt werden.

Zur Abdichtung zwischen der Seitenwand 19 der Wanne und der Isolierplatte 32 und somit zur Abdichtung der Aussparungen 26 wird ein dauerelastischer Dicht- und Klebstoff 42 verwendet, der flächig zwischen der Isolierplatte und der Seitenwand 19 des Gehäuses angeordnet ist. Als dauerelastischer Dicht- und Klebstoff ist insbesondere ein Klebstoff mit Polysulfid geeignet, wie er im Flugzeugbau zum Verbinden von zwei Bauteilen aus einer Aluminiumlegierung verwendet wird.

Zur Montage der Isolierplatte 32 an der Seitenwand 19 des Gehäuses wird der dauerelastische Dicht- und Klebstoff entweder auf die Seitenwand des Gehäuses oder die Seite der Isolierplatte 32 flächig aufgetragen, die der Seitenwand des Gehäuses zugewandt ist. Dann wird die Isolierplatte 32 gegen die Seitenwand 19 gepreßt, wobei die Abstandshalter 40 verhindern, daß der Dichtund Klebstoff 42 vollständig aus dem Spalt zwischen der Isolierplatte und der Seitenwand 19 herausgepreßt wird, und eine konstante Schichtdicke gewährleisten.

Damit die Wanne 10 des Gehäuses mit der Isolierplatte 32 nicht in einer Presse verbleiben muß, bis der Dicht- und Klebstoff 42 ausgehärtet ist, kann die Isolierplatte 32 durch mehrere Niete 44 (siehe Figur 6) an der Seitenwand 19 der Wanne 10 befestigt werden. Die Niete sind jedoch für die mechanische Verbindung zwischen der Isolierplatte 32 und der Seitenwand 19 der Wanne 10 nicht erforderlich, wenn der dauerelastische Dicht- und Klebstoff ausgehärtet ist.

Nach der Anbringung der Isolierplatte 32 mit der darauf befindlichen Leistungselektronik 34 wird die Wanne 10 mit einer Kühlflüssigkeit gefüllt, die nahezu jede beliebige, niedrig siedende Flüssigkeit sein kann. Besonders geeignet ist Fluorkohlenwasserstoff. Abschließend wird auf der Wanne 10 der Deckel 12 montiert, wobei dieser von den Biegelaschen 30 auf den Rand 28 der Wanne gedrückt wird.

### Bezugszeichenliste:

- 5:: Gehäuse
- 10:: Wanne
- 12:: Deckel
- 14:: Abdeckung
- 16:: Seitenwand
- 17:: Seitenwand
- 18:: Seitenwand
- 19:: Seitenwand
- 20:: Boden
- 22:: Sicke
- 24:: Kreuzsicke
- 26:: Aussparung
- 28:: Rand der Wanne
- 30:: Biegelasche
- 32:: Isolierplatte
- 34:: Leistungselektronik-Bauteile
- 36:: Stromdurchführung
- 38:: Depotnut
- 40:: Abstandshalter
- 42:: Dicht- und Klebstoff
- 44:: Niete

## Patentansprüche

1. Hermetisch dichtes Gehäuse für eine Leistungselektronik, mit einer Wanne (10), die aus Metall besteht und mindestens eine Seitenwand (19) aufweist, in der mindestens eine Aussparung (26) vorgesehen ist, einem Deckel (12), der hermetisch dicht an der Wanne (10) angebracht werden kann, und einer Isolierplatte (32), die aus Kunststoff besteht und an der mindestens eine Stromdurchführung (36) vorgesehen ist, wobei die Isolierplatte (32) so an der Seitenwand (19) befestigt ist, daß die Stromdurchführung (36) durch die Aussparung (26) hindurchragt, **dadurch gekennzeichnet, daß** zwischen der Isolierplatte (32) und der Seitenwand (19) des Gehäuses flächig ein dauerelastischer Dicht- und Klebstoff (42) angeordnet ist.

2. Gehäuse nach Anspruch 1, **dadurch gekennzeichnet, daß** die Wanne (10) aus Stahl besteht.

3. Gehäuse nach Anspruch 1, **dadurch gekennzeichnet, daß** die Wanne (10) aus Aluminium oder einer Aluminiumlegierung besteht.

4. Gehäuse nach einem der vorhergehenden Ansprüche, **dadurch gekennzeichnet, daß** auf der der Seitenwand (19) des Gehäuses zugewandten Seite der Isolierplatte (32) eine Depotnut (38) vorgesehen ist, die sich entlang dem Außenrand der Isolierplatte (32) erstreckt.

5. Gehäuse nach Anspruch 4, **dadurch gekennzeichnet, daß** die Tiefe der Depotnut (38) zwischen 0,5 und 1,5 mm beträgt.

6. Gehäuse nach einem der vorhergehenden Ansprüche, **dadurch gekennzeichnet, daß** auf der der Seitenwand (19) des Gehäuses zugewandten Seite der Isolierplatte (32) mehrere Abstandshalter (40) vorgesehen sind, die sich an der Seitenwand (19) abstützen.

7. Gehäuse nach Anspruch 6, **dadurch gekennzeichnet, daß** die Abstandshalter (40) mehrere pyramidenförmige Vorsprünge sind.

8. Gehäuse nach Anspruch 6 oder Anspruch 7, **dadurch gekennzeichnet, daß** die Abstandshalter (40) eine Höhe zwischen 0,1 und 0,5 mm haben.

9. Gehäuse nach einem der vorhergehenden Ansprüche, **dadurch gekennzeichnet, daß** mehrere Niete (44) vorgesehen sind, mittels denen die Isolierplatte (32) an der Seitenwand (19) befestigt ist.

10. Gehäuse nach einem der vorhergehenden Ansprüche, **dadurch gekennzeichnet, daß** die Isolierplatte (32) aus einem teilkristallinen, kapillardichten Kunststoff besteht.

11. Gehäuse nach einem der vorhergehenden Ansprüche, **dadurch gekennzeichnet, daß** die Isolierplatte (32) aus einem faserverstärkten Kunststoff besteht.

12. Gehäuse nach einem der vorhergehenden Ansprüche, **dadurch gekennzeichnet, daß** die Isolierplatte (32) aus PPS besteht.

13. Gehäuse nach einem der vorhergehenden Ansprüche, **dadurch gekennzeichnet, daß** der dauerelastische Dicht- und Klebstoff (42) Polysulfid enthält.
